(19) Europäisches Patentamt European Patent Office Office européen des brevets

(11) **EP 3 978 937 A1**

(12) **EUROPEAN PATENT APPLICATION**
published in accordance with Art. 153(4) EPC

(43) Date of publication:
06.04.2022 Bulletin 2022/14

(21) Application number: 19931256.2

(22) Date of filing: 27.05.2019

(51) International Patent Classification (IPC):
*G01R 15/09* (2006.01)   *G01K 7/22* (2006.01)

(52) Cooperative Patent Classification (CPC):
**G01K 7/22; G01R 15/09**

(86) International application number:
**PCT/CN2019/088661**

(87) International publication number:
**WO 2020/237486 (03.12.2020 Gazette 2020/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **GUANGDONG OPPO MOBILE TELECOMMUNICATIONS CORP., LTD.**
**Wusha, Chang'an**
**Dongguan**
**Guangdong 523860 (CN)**

(72) Inventor: **YANG, Xin**
**Dongguan, Guangdong 523860 (CN)**

(74) Representative: **Ipside**
**7-9 Allées Haussmann**
**33300 Bordeaux Cedex (FR)**

(54) **TEMPERATURE MEASUREMENT METHOD AND APPARATUS, AND STORAGE MEDIUM**

(57) A method for measuring temperature includes: measuring a current voltage corresponding to a thermistor based on a current resistor that is connected in series with the thermistor in the crystal oscillator, wherein the current resistor is any one of resistors in a resistor array; switching the resistor into another resistor in the resistor array, enabling the another resistor to be connected in series with the thermistor, based on a preset switching rule, when the current voltage is greater or lower than a preset voltage range, until a target resistor in the resistor array is connected in series with the thermistor, and a target voltage corresponding to the thermistor is measured to be within the preset voltage range; and determining temperature of the crystal oscillator based on connected power supply voltage, the target resistor and the target voltage.

A current voltage corresponding to a thermistor may be measured based on a current resistor that connects in series with the thermistor in the crystal oscillator. The current resistor is any one of resistors in a resistor array. — S101

when the current voltage exceeds or is lower than a preset voltage range, the resistor connected in series with the thermistor may be switched to another resistor in the resistor array based on a preset switching rule, enabling the another resistor to connect in series with the thermistor, until a target resistor in the resistor array is connected in series with the thermistor, and a target voltage corresponding to the thermistor is measured to be in the preset voltage range. — S102

temperature of the crystal oscillator may be determined based on the connected power supply voltage, the target resistor and the target voltage — S103

FIG. 1

**Description**

**TECHNICAL FIELD**

The present disclosure relates to the field of crystal oscillators, and in particular to a method for measuring temperature, a device for measuring temperature, and a storage medium.

**BACKGROUND**

A crystal oscillator is not only widely applied in various types of oscillation circuits, such as a color television, a computer, and a remote control, but also serves as a frequency generator of a communication system, generates a clock signal for a data processing device, and provides a reference signal for a specific system. A frequency error in the crystal oscillator may be caused by temperature variation in most cases.

In the art, a temperature-compensated crystal oscillator may be configured to adjust a resonant frequency by sensing surrounding temperature, thus eliminating the frequency error caused by temperature changes. However, the temperature-compensated crystal oscillator may be costly and have limited applications. Currently, a free-oscillating crystal oscillator may be applied more widely. A thermistor of the crystal oscillator may be connected in series with an external fixed resistor, and an analog-to-digital converter may be configured for measuring the temperature of the crystal oscillator. Temperature compensation may be achieved by changing a final frequency generated by a radio frequency circuit at the back. In this way, the temperature measurement is less costly, and multiple frequencies may be generated in the system. Each of the multiple frequencies may correspond to a unique compensation strategy, and the multiple frequencies do not interfere with each other. However, when the temperature is relatively low or relatively high, the thermistor and the external fixed resistor are not in a same order of magnitude. Even if the thermistor changes to some extent, a voltage signal input to the analog-to-digital converter changes very little. The input voltage signal may be close to a power voltage or close to zero. In this case, performance of the analog-to-digital converter may be poor. Therefore, accuracy of the temperature measurement may be low, temperature measurement at the relatively low temperature or at the relatively high temperature may not be achieved, and a temperature range that can be measured may be limited.

**SUMMARY OF THE DISCLOSURE**

According to the present disclosure, a method for measuring temperature is provided. The resistor, which is in a resistor array and connects in series with the thermistor of the crystal oscillator, may be switched to perform temperature measurement. In this way, the accuracy of temperature measurement may be improved, and the temperature range that can be measured may be expanded.

Technical solutions of the present disclosure may be achieved as follows.

A method for measuring temperature includes:

measuring a current voltage corresponding to a thermistor based on a current resistor that is connected in series with the thermistor in the crystal oscillator, wherein the current resistor is any one of resistors in a resistor array;

switching the resistor into another resistor in the resistor array, enabling the another resistor to be connected in series with the thermistor, based on a preset switching rule, when the current voltage is greater or lower than a preset voltage range, until a target resistor in the resistor array is connected in series with the thermistor, and a target voltage corresponding to the thermistor is measured to be within the preset voltage range;

determining temperature of the crystal oscillator based on connected power supply voltage, the target resistor and the target voltage.

In the above technical solution, the operation of switching the resistor into another resistor in the resistor array, enabling the another resistor to be connected in series with the thermistor, based on a preset switching rule, includes:

successively switching the resistors in the resistor array to be connected in series with the thermistor when the current voltage is greater than the preset voltage range, wherein each of the switched resistors has a nominal resistance value greater than a resistance value of the current resistor; and

successively switching the resistors in the resistor array to be connected in series with the thermistor when the current voltage is lower than the preset voltage range, wherein each of the switched resistors has a nominal resistance value less than a resistance value of the current resistor.

In the above technical solution, after the operation of measuring a current voltage corresponding to a thermistor, the method further includes:

successively determining a corrected resistance value of the resistor that is switched to be connected in series with the thermistor, in a process of switching the resistors in the resistor array to connect in series with the thermistor based on the preset switching rule, until a corrected resistance value of the target resistor is determined.

In the above technical solution, the operation of successively determining a corrected resistance value of the resistor that is switched to be connected in series with the thermistor, until a corrected resistance value of the target resistor is determined, includes:

measuring a first voltage corresponding to the thermistor, when the current resistor is switched into a first resistor in the resistor array, enabling the first resistor to be connected in series with the thermistor;
obtaining a corrected resistance value of the current resistor;
determining a corrected resistance value of the first voltage based on based on the power supply voltage, the current voltage, the corrected resistance value of the current resistor, and the first voltage; and
in response to the first resistor being not the target resistor, switching the first resistor into a second resistor in the resistor array, enabling the second resistor to connect in series with the thermistor, measuring a second voltage corresponding to the thermistor, and determining a corrected resistance value of the second resistor based on the power supply voltage, the first voltage, the corrected resistance value of the first voltage and the second voltage, until a corrected resistance value of the target resistor being determined.

In the above technical solution, the operation of obtaining the corrected resistance value of the current resistor, includes:
determining a nominal resistance value of the current resistor as the corrected resistance value of the current resistor when the current resistor connected in series with the thermistor is a first resistor of the resistor array.

In the above technical solution, the operation of obtaining the corrected resistance value of the current resistor, includes:

obtaining a corrected resistance value of a historical resistor in the resistor array and a historical voltage corresponding to the thermistor connected in series with the historical resistor when the current resistor connected in series with the thermistor is not a first resistor in the resistor array, wherein the historical resistor is a resistor which is in the resistor array and is connected in series with the thermistor before the current resistor is connected; and
determining the corrected resistance value of the current resistor based on the power supply voltage, the corrected resistance value of the historical resistor, the historical voltage and the current voltage.

In the above technical solution, the operation of determining temperature of the crystal oscillator based on connected power supply voltage, the target resistor and the target voltage, includes:

obtaining a corrected resistance value of the target resistor; and
determining the temperature based on the power supply voltage, the corrected resistance value of the target resistor and the target voltage.

In the above technical solution, after the operation of determining temperature of the crystal oscillator based on connected power supply voltage, the target resistor and the target voltage, the method further includes:
transmitting the temperature to a clock generator, such that the clock generator corrects an oscillation frequency output from the crystal oscillator based on the temperature.

The present disclosure provides an apparatus for measuring temperature, including: a resistor array, an analog-to-digital converter, and a processor.

The analog-to-digital converter is configured to measure a current voltage corresponding to a thermistor in a crystal oscillator based on a current resistor that connects in series with the thermistor, wherein the current resistor is any one of resistors in the resistor array.

The processor is configured to: switch the resistor connected in series with the thermistor into another resistor in the resistor array based on a preset switching rule, when the current voltage is greater than or lower than a preset voltage range, until a target resistor in the resistor array is connected in series with the thermistor, and a target voltage corresponding to the thermistor is measured to be within the preset voltage range; and determine temperature of the crystal oscillator based on connected power supply voltage, the target resistor and the target voltage.

In the above apparatus, the processor is configured to: successively switch the resistors in the resistor array to be connected in series with the thermistor when the current voltage is greater than the preset voltage range, wherein each of the switched resistors has a nominal resistance value greater than a resistance value of the current resistor; and successively switch the resistors in the resistor array to be connected in series with the thermistor when the current voltage is lower than the preset voltage range, wherein each of the switched resistors has a nominal resistance value less than a resistance value of the current resistor.

In the above apparatus, the processor is configured to: successively determine a corrected resistance value of the resistor that is switched to be connected in series with the thermistor, in a process of switching the resistors in the resistor array to connect in series with the thermistor based on the preset switching rule, until a corrected resistance value of the target resistor is determined.

In the above apparatus, the processor is configured to: measure a first voltage corresponding to the thermistor, when the current resistor is switched into a first resistor in the resistor array, enabling the first resistor to be connected in series with the thermistor; obtaining a corrected resistance value of the current resistor; determining a corrected resistance value of the first voltage based on based on the power supply voltage, the current voltage, the corrected resistance value of the current resistor, and the first voltage; and in response to the first resistor being not the target resistor, switch the first resistor into a second resistor in the resistor array to enable the second resistor to connect in series with the thermistor, and measure a second voltage corresponding to the thermistor, and determine a corrected resistance value of the second resistor based on the power supply voltage, the first voltage, the corrected resistance value of the first voltage and the second voltage, until a corrected resistance value of the target resistor being determined.

In the above apparatus, the processor is configured to: determine a nominal resistance value of the current resistor as the corrected resistance value of the current resistor when the current resistor connected in series with the thermistor is a first resistor of the resistor array.

In the above apparatus, the processor is configured to: obtain a corrected resistance value of a historical resistor in the resistor array and a historical voltage corresponding to the thermistor connected in series with the historical resistor when the current resistor connected in series with the thermistor is not a first resistor in the resistor array, wherein the historical resistor is a resistor which is in the resistor array and is connected in series with the thermistor before the current resistor is connected; and determine the corrected resistance value of the current resistor based on the power supply voltage, the corrected resistance value of the historical resistor, the historical voltage and the current voltage.

In the above apparatus, the processor is configured to: obtain a corrected resistance value of the target resistor; and determine the temperature based on the power supply voltage, the corrected resistance value of the target resistor and the target voltage.

In the above apparatus, the processor is configured to: transmit the temperature to a clock generator, such that the clock generator corrects an oscillation frequency output from the crystal oscillator based on the temperature.

The present disclosure provides a computer-readable storage medium. The storage medium stores a computer program, the computer program is configured to implement the method for measuring temperature as described in the above when being executed by a processor and an analog-to-digital converter.

Therefore, according to the present disclosure, based on the current resistor that is connected in series with the thermistor in the crystal oscillator, a current voltage corresponding to the thermistor may be measured. The current resistor may be any one of the resistors in the resistor array. When the current voltage exceeds or is lower than a preset voltage range, the resistor that is connected in series with the thermistor may be switched with another resistor in the resistor array based on a preset switching rule, until a target resistor in the resistor array is connected in series with the thermistor, and a target voltage corresponding to the thermistor is measured as being within a preset voltage range. Based on an connected power voltage, the target resistor and the target voltage, the temperature of the crystal oscillator is determined. In other words, according to the present disclosure, the resistor, which is in the resistor array and connects in series with the thermistor of the crystal oscillator, may be switched to perform temperature measurement. In this way, the accuracy of temperature measurement may be improved, and the temperature range that can be measured may be expanded.

**BRIEF DESCRIPTION OF THE DRAWINGS**

FIG. 1 is a flow chart I of a method for measuring temperature according to an embodiment of the present disclosure.
FIG. 2 is a schematic view of an exemplary apparatus for measuring temperature according to an embodiment of the present disclosure.
FIG. 3 is a flow chart of determining a corrected resistance value of a resistor according to an embodiment of the present disclosure.
FIG. 4 is a flow chart II of a method for measuring temperature according to an embodiment of the present disclosure.
FIG. 5 is a structural schematic view of an apparatus for measuring temperature according to an embodiment of the present disclosure.

## DETAILED DESCRIPTION

Technical solutions in the embodiments of the present disclosure will be clearly and completely described by referring to the accompanying drawings in the embodiments of the present disclosure. It will be understood that the specific embodiments described herein are used only for the purpose of explaining the disclosure, but does not limit the present disclosure. To be further noted that, for a concise description, only portions related to the present disclosure are shown in the accompanying drawings.

Embodiment I

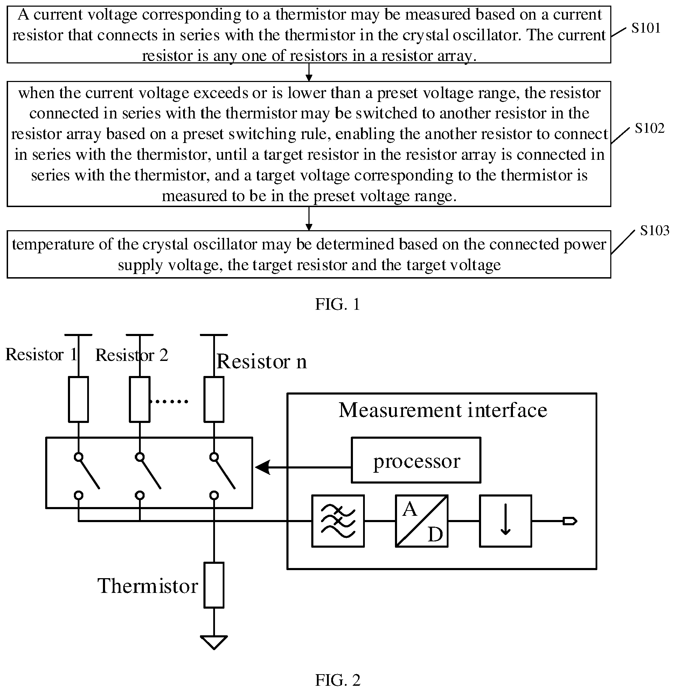

Embodiments of the present disclosure provide a method for measuring temperature. FIG. 1 is a flow chart I of a method for measuring temperature according to an embodiment of the present disclosure. As shown in FIG. 1, the method substantially includes following operations.

In an operation S101, a current voltage corresponding to a thermistor may be measured based on a current resistor that connects in series with the thermistor in the crystal oscillator. The current resistor is any one of resistors in a resistor array.

In the present embodiment, a temperature measurement apparatus may measure the current voltage corresponding to the thermistor based on the current resistor that connects in series with the thermistor in the crystal oscillator.

To be noted that, in the present embodiment, the temperature measurement apparatus may include a resistor array, an analog-to-digital converter, and a processor. The resistor array includes a plurality of resistors and a plurality of switches. One switch may control one resistor to connect in series with the thermistor. The analog-to-digital converter may measure a respective voltage of the thermistor when the thermistor is connected in series with each of the plurality of resistors in the resistor array. That is, the digital-to-analog converter in the temperature measurement apparatus may measure the current voltage corresponding to the thermistor based on the current resistor that connects in series with the thermistor in the crystal oscillator. The processor may control a connection state between each resistor in the resistor array and the thermistor and calculate a corrected resistance value of each resistor in the resistor array based on the various voltages measured by the analog-to-digital converter, and may determine temperature of the crystal oscillator based on the voltage.

FIG. 2 is a schematic view of an exemplary apparatus for measuring temperature according to an embodiment of the present disclosure. As shown in FIG. 2, the temperature measurement apparatus may include not only the resistor array, the analog-to-digital converter and the processor, but also include a low-pass filter and an extractor. The resistor array includes n resistors. The low-pass filter may low-pass filter a voltage signal that is divided to the thermistor from the power supply voltage. Subsequently, the low-pass filter may output the voltage signal to the analog-to-digital converter. That is, the voltage corresponding to the thermistor may be measured. Subsequently, as the voltage is continuously measured in real time, the extractor may extract a voltage from a plurality of voltages according to a certain rule. In this way, the extracted voltage may be taken as the current voltage. Alternatively, an average value of a plurality of voltages extracted within a time period adjacent to a current time point may be calculated and taken as the current voltage. Of course, the extractor may also directly take the voltage output by the analog-to-digital converter in real time as the current voltage, and provide the output voltage to the processor for further temperature measurement. Of course, the temperature of the crystal oscillator may always be determined in real time. The processor, the low-pass filter, the analog-to-digital converter and the extractor may be configured as a whole, i.e., as a measurement interface. In addition, the temperature measurement apparatus may include other components, for example, a memory, which may store the voltage and/or the determined temperature. The present disclosure does not limit the included components of the apparatus.

To be noted that, in the present embodiment, a resistance value of each of the plurality of resistors in the resistor array may be adapted in advance according to demands. The present disclosure does not limit the specific number of resistors included in the resistor array and the resistance values of the resistors.

To be noted that, in the present embodiment, the current resistor is the resistor that connects in series with the thermistor at the current time point. The analog-to-digital converter may directly measure a current resistance value corresponding to the thermistor at the current time point.

It shall be understood that, in the art, the temperature measurement apparatus for measuring the temperature of the crystal oscillator may usually be a fixed resistor connected in series with the thermistor of the crystal oscillator. The temperature of the crystal oscillator is continuously measured based on the fixed resistor. However, when the temperature of the crystal oscillator is excessively high or excessively low, the voltage signal input at the analog-to-digital converter may be larger or smaller, resulting in a lower sensitivity of the analog-to-digital converter. That is, the analog-to-digital converter may not operate at an optimal operating condition. Therefore, a final measured voltage corresponding to the thermistor may be inaccurate, such that the temperature determined based on the voltage may also be inaccurate. Practically, only a small range of temperature values may be measured, and it may be difficult to measure the temperature properly when the temperature is relatively high or low. According to the embodiment of the present disclosure, the resistor array includes the plurality of resistors. Therefore, the temperature measurement apparatus may determine the resistor that needs to be connected in series with the thermistor to achieve temperature measurement based on an actual measurement state. In this way, the analog-to-digital converter may be in a better operating state, the accuracy of the temperature measurement may be improved, and the range of the temperature that is able to be measured may be expanded.

In an operation S102, when the current voltage exceeds or is lower than a preset voltage range, the resistor connected in series with the thermistor may be switched to another resistor in the resistor array based on a preset switching rule, until a target resistor in the resistor array is connected in series with the thermistor, and a target voltage corresponding to the thermistor is measured to be in the preset voltage range.

In the present embodiment, when the current voltage exceeds or is lower than the preset voltage range, the temperature measurement apparatus may switch the resistor connected in series with the thermistor into another resistor in the resistor array based on the preset switching rule, until the target resistor in the resistor array is connected in series with the thermistor, and the target voltage corresponding to the thermistor is measured to be in the preset voltage range. The target voltage may be any voltage measured to be in the preset voltage range when the target resistor is connected in series with the thermistor. The present disclosure does not limit a value of the target voltage.

To be noted that, in the present embodiment, a user may set the preset voltage range in the temperature measurement apparatus according to demands. The specific preset voltage range may be set to be around half of the power supply voltage. The power supply voltage may be an operating voltage connected to the current temperature measurement apparatus. The present disclosure does not limit the preset voltage range.

To be exemplary, in the present embodiment, the preset voltage range may be: greater than or equal to 40% of the power supply voltage and less than or equal to 70% of the power supply voltage. After the temperature measurement apparatus measures the current voltage, the temperature measurement apparatus may determine whether the current voltage is in the preset voltage range.

In detail, in the present embodiment, the operation of the temperature measurement apparatus switching the resistor connected in series with the thermistor into another resistor in the resistor array based on the preset switching rule may include following operations. When the current voltage exceeds the preset voltage range, the temperature measurement apparatus may successively switch the resistors in the resistor array to be connected in series with the thermistor. Each of the switched resistors has a nominal resistance value greater than a resistance value of the current resistor. When the current voltage is lower than the preset voltage range, the temperature measurement apparatus may successively switch the resistors in the resistor array to be connected in series with the thermistor. Each of the switched resistors has the nominal resistance value lower than the resistance value of the current resistor.

It shall be understood that, in the present embodiment, the current voltage exceeding the preset voltage range may indicate that the current voltage is excessively large. Correspondingly, before the analog-to-digital converter in the temperature measurement apparatus measures the current voltage, the voltage signal input to the analog-to-digital converter may be excessively large, sensitivity of the analog-to-digital converter may be poor, and the current voltage measured in this case may be inaccurate. In this case, the voltage signal input to the analog-to-digital converter needs to be reduced. Therefore, based on the principle of connecting the thermistor in series with the resistor in the resistor array to divide the power supply voltage, the temperature measurement apparatus may switch to the resistor in the resistor array to connect in series with the thermistor, wherein the connected resistor has the nominal resistance value greater than the resistance value of the current resistor. In this way, the voltage signal input to the analog-to-digital converter maybe reduced. Of course, when the current voltage is lower than the preset voltage range, it may indicate that the current voltage is excessively small. The temperature measurement apparatus may switch to the resistor in the resistor array to connect in series with the thermistor, wherein the connected resistor has the nominal resistance value lower than the resistance value of the current resistor. In this way, the voltage signal input to the analog-to-digital converter maybe increased.

To be noted that, in the present embodiment, each resistor included in the resistor array has a respective nominal resistance value, i.e., a resistance value that should be reached. The temperature measurement apparatus may directly obtain the nominal resistance value and take the nominal resistance value as a basis for resistor switching.

To be exemplary, in the present embodiment, the resistor array includes N resistors, recorded as A1, A2, ..., and An, respectively. Nominal resistance values may increase from A1 to An. The current resistor A3 may be connected in series with the thermistor. The measured voltage corresponding to the thermistor exceeds the preset voltage range. Therefore, the temperature measurement apparatus may switch the resistor A3 into resistor A4. If the measured voltage corresponding to the thermistor still exceeds the preset voltage range, the resistor A4 may be switched into resistor A5, and so on, until the resistor Ax is switched to be connected in series with the thermistor, enabling the voltage corresponding to the thermistor to be in the preset voltage range. In this case, the resistor Ax may be the target resistor, and x may be a natural number greater than 3 and less than or equal to n.

It shall be understood that, in the present embodiment, each time the resistor connected in series with the thermistor is switched, the temperature measuring apparatus may measure the corresponding voltage through the analog-to-digital converter for determination. Of course, the resistors connected in series with the thermistor may be switched successively, and if the resistor that meets the preset voltage range is switched to be connected in series, the resistor may be the target resistor, and switching the resistors in the resistor array may be terminated.

It shall be understood that, in the present embodiment, the target resistor may be connected in series with the thermistor. The measured target voltage corresponding to the thermistor being in the preset voltage range may indicate that the voltage signal input to the analog-to-digital converter may be close to half of the power supply voltage at this time. The analog-to-digital converter may exhibit better performance. In this case, the resistance value of the target resistor may be close to the resistance value of the thermistor. When the thermistor changes as the temperature changes, the voltage signal input to the analog-to-digital converter may also change to some extent. In this way, the sensitivity of the temperature measurement may be relatively high. When the target voltage is taken for calculating the temperature of the crystal oscillator, the temperature value may be more accurate.

To be noted that, in the present embodiment, after the temperature measurement apparatus measures the current voltage corresponding to the thermistor, following operations may be performed. In the process of switching the resistors in the resistor array connected in series with the thermistor based on the preset switching rule, the corrected resistance value of each resistor that is switched to be connected in series may be determined successively, the corrected resistance value of the target resistor is determined.

In detail, in the present embodiment, the operation of the temperature measurement apparatus successively determining the corrected resistance value of each resistor that is switched to be connected in series, until the corrected resistance value of the target resistor being determined, may include following operations. When the current resistor is switched into the first resistor, enabling the first resistor in the resistor array to be connected in series with the thermistor, a first voltage corresponding to the thermistor may be measured. The corrected resistance value of the current resistor may be obtained. The corrected resistance value of the first resistor may be determined based on the power supply voltage, the current voltage, the corrected resistance value of the current resistor and the first voltage. When it is determined that the first resistor is not the target resistor, the first resistor may be switched into the second resistor, enabling the second resistor in the resistor array to connect in series with the thermistor, and the second voltage corresponding to the thermistor may be measured. The corrected resistance value of the second resistor may be determined based on the power supply voltage, the first voltage, the corrected resistance value of the first voltage and the second voltage. The switching operation is performed until the corrected resistance value of the target resistor is determined.

To be noted that, in the present embodiment, in the process of the temperature measurement apparatus switching the connected resistors, the corrected resistance value of the resistor that is switched to be connected in series may be determined based on the corrected resistance value of a previous resistor connected in series with the thermistor, the voltage corresponding to the thermistor when connected in series with the previous resistor, the voltage corresponding to the thermistor when connected in series with the resistor switched to, and the power supply voltage. In addition, the first resistor may be the resistor determined based on the preset switching rule, and is not limited by the present disclosure.

It shall be understood that, in the present embodiment, in order to avoid additional offsets caused by switching between resistors, the resistance value of the resistor needs to be adapted and corrected, such that the corrected resistance values may be taken in subsequent calculations to obtain more accurate results.

To be noted that, in the present embodiment, each time the temperature measurement apparatus switches the resistor to be connected in series with the thermistor, the corrected resistance value of the switched resistor may be determined.

In detail, in the present embodiment, the temperature measurement apparatus may determine the corrected resistance value of the first resistor based on the following equations (1) and (2) based on the power supply voltage, the current voltage, the corrected resistance value of the current resistor and the first voltage.

$$V_{\mathrm{ADC1}} = V_{\mathrm{DD}} \times R_{\mathrm{TH1}}/(R_{\mathrm{TH1}} + R_{X1}) \qquad (1)$$

$$V_{\mathrm{ADC2}} = V_{\mathrm{DD}} \times R_{\mathrm{TH1}}/(R_{\mathrm{TH1}} + R_{X2}) \qquad (2)$$

In the equations, the $V_{\mathrm{ADC1}}$ may be the current voltage, the $V_{\mathrm{DD}}$ may be the power supply voltage, the $R_{X1}$ may be the corrected resistance value of the current resistor, the $V_{\mathrm{ADC2}}$ may be the first voltage, the $R_{\mathrm{TH1}}$ may be the current resistance value of the thermistor. The current resistance value of the thermistor may remain constant while the resistors are being switched. The $R_{\mathrm{TH1}}$ may be calculated according to the equation (1), and the $R_{\mathrm{TH1}}$ may be taken into the equation (2) to calculate the corrected resistance value of the first resistor, $R_{x2}$.

It shall be understood that, in the present embodiment, in response to the first voltage still exceeding or being lower than the preset voltage range, the first resistor may not be the target resistor, and the second resistor may be switched to be connected in series with the thermistor. The present disclosure does not limit the second resistor. The above operations may be performed to determine the corrected resistance value of the second resistor. That is, the second voltage corresponding to the thermistor when being connected in series with the second resistor may be measured. The corrected resistance value of the second resistor may be calculated based on the second voltage, the first voltage, the corrected resistance value of the first resistor, and the power supply voltage, and based on the equation (1) and the equation (2). The above operations may be performed continuously until the corrected resistance value of the target resistor is determined.

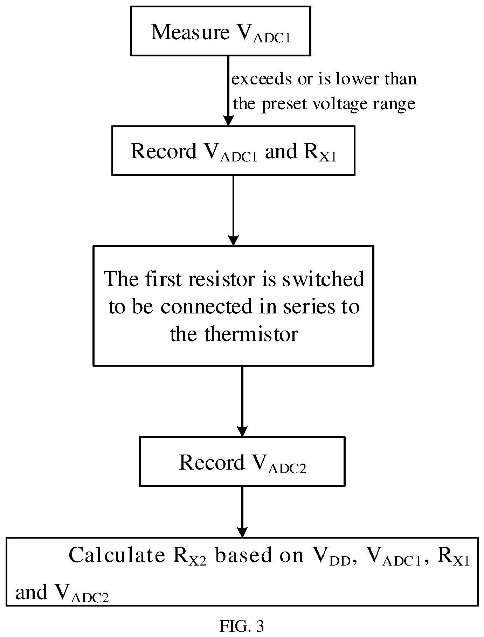

FIG. 3 is a flow chart of determining a corrected resistance value of a resistor according to an embodiment of the present disclosure. As shown in FIG. 3, the temperature measurement apparatus firstly determines whether the current voltage $V_{ADC1}$ corresponding to the thermistor connected in series with the current resistor exceeds or is lower than the preset voltage range. When the current voltage $V_{ADC1}$ exceeds or is lower than the preset voltage range, the current voltage $V_{ADC1}$ and the corrected resistance value $R_{X1}$ of the current resistor may be recorded. Subsequently, the current resistor is switched into the first resistor based on the preset switching rule, enabling the first resistor to be connected in series with the thermistor, the first voltage $V_{ADC2}$ may be recorded. At last, the corrected resistance value Rx2 of the first resistor may be calculated based on the connected power supply voltage $V_{DD}$, the $V_{ADC1}$, the $R_{X1}$ and the $V_{ADC2}$.

To be noted that, in the present embodiment, the temperature measurement apparatus obtains the corrected resistance value of the current resistor in two ways. In detail, in a first way, when the current resistor is a first resistor of the resistor array connected in series with the thermistor, the nominal resistance value of the current resistor may be determined as the corrected resistance value of the current resistor. In a second way, when the current resistor is not the first resistor in the resistor array connected in series with the thermistor, a corrected resistance value of a historical resistor in the resistor array and a historical voltage corresponding to the thermistor connected in series with the historical resistor may be obtained. The corrected resistance value of the current resistor may be determined based on the power supply voltage, the corrected resistance value of the historical resistor, the historical voltage and the current voltage. The historical resistor may be the resistor which is in the resistor array and is connected in series with the thermistor before the current resistor is connected.

To be noted that, in the present embodiment, the historical resistor is the previous resistor connected in series with the thermistor before the current resistor is switched to be connected. The process of determining the corrected resistance value of the current resistor based on the power supply voltage, the corrected resistance value of the historical resistor, the historical voltage and the current voltage may be the same as the process of determining the corrected resistance value of the first resistor described in the above and will not be repeated here.

To be noted that, in the present embodiment, the temperature measurement apparatus may include a memory. After determining the corrected resistance value of each resistor, the corresponding corrected resistance value may be stored in the memory for subsequent data processing, such as for temperature calculation, and so on. The present disclosure does not limit a specific type of the memory. In addition, after the corrected resistance value of the target resistor is determined, the corrected resistance value of the resistor may also be updated while switching the resistor if the resistor needs to be switched according to demands. As the temperature changes, the resistance value of the resistor may change slightly. In order to obtain more accurate temperature, the resistance value needs to be corrected constantly for each switching process to obtain an updated corrected resistance value.

To be noted that, in the present embodiment, the first resistor in the resistor array connected in series with the thermistor may be determined as a reference resistor. That is, the nominal resistance value of the first resistor may be determined as the corrected resistance value of the first resistor.

In an operation S103, temperature of the crystal oscillator may be determined based on the connected power supply voltage, the target resistor and the target voltage.

In the present embodiment, after the temperature measurement apparatus connects the target resistor in series with the thermistor, the temperature measurement apparatus may determine the temperature of the crystal oscillator based on the connected power supply voltage, the target resistor and the target voltage.

In detail, in the present embodiment, the operation of the temperature measurement apparatus determining the temperature of the crystal oscillator based on the connected power supply voltage, the target resistor, and the target voltage, may include following operations. The corrected resistance value of the target resistor may be obtained. The temperature may be determined based on the power supply voltage, the corrected resistance value of the target resistor, and the target voltage.

To be noted that, in the present embodiment, the target voltage is any voltage within the preset voltage range measured by the temperature measurement apparatus after the target resistor is connected in series with the thermistor. The present disclosure does not limit the preset voltage range.

It shall be understood that, in the present embodiment, while switching the resistor, the temperature measurement apparatus may successively determine the corrected resistance value of each resistor that is switched to be connected, until the corrected resistance value of the target resistor is determined. Therefore, the temperature measurement apparatus may directly obtain the corrected resistance value of the target resistor while determining the temperature.

In detail, in the present embodiment, the temperature measurement apparatus may calculate the resistance value of the thermistor in real time while the thermistor is connected in series with the target resistance based on equation (3).

$$V_{\mathrm{ADC}} = V_{\mathrm{DD}} \times R_{\mathrm{TH2}}/(R_{\mathrm{TH2}} + R_{Xm}) \qquad (3)$$

In the equation, the $V_{\mathrm{ADC}}$ may be the target voltage, the $V_{\mathrm{DD}}$ may be the power supply voltage, and the $R_{xm}$ may be the corrected resistance value of the target resistor. By taking the three values into the equation (3), the resistance value of the thermistor $R_{\mathrm{TH2}}$ may be determined at this moment.

In detail, in the present embodiment, after the temperature measurement apparatus determines the resistance value $R_{\mathrm{TH2}}$ of the thermistor, the resistance value $R_{\mathrm{TH2}}$ of the thermistor may be taken into an equation (4) to calculate the temperature of the crystal oscillator.

$$R_{\mathrm{TH2}} = R_0 e^{B(1/T - 1/T0)} \qquad (4)$$

In the equation, the TO may be 30 degrees, the Ro may be the resistance value of the thermistor at the temperature of T0, and may specifically be 100 kQ, the B may be a thermistor constant. $R_{\mathrm{TH2}}$ may be taken into the equation (4) to obtain the temperature T of the crystal oscillator at this moment.

It shall be understood that, in the present embodiment, after the target resistor and the thermistor are connected in series, the temperature of the thermistor still changes constantly. Therefore, the temperature measurement apparatus may measure a voltage at a certain time point, and the measured voltage may exceed or may be lower the preset voltage range, after the temperature measurement apparatus measures the target voltage within a period of time to be in the preset voltage range. In this case, the target voltage may be regarded as the above-mentioned current resistor, and another resistor switching process may be performed to determine a new target resistor to ensure the accuracy and the range of temperature measurement.

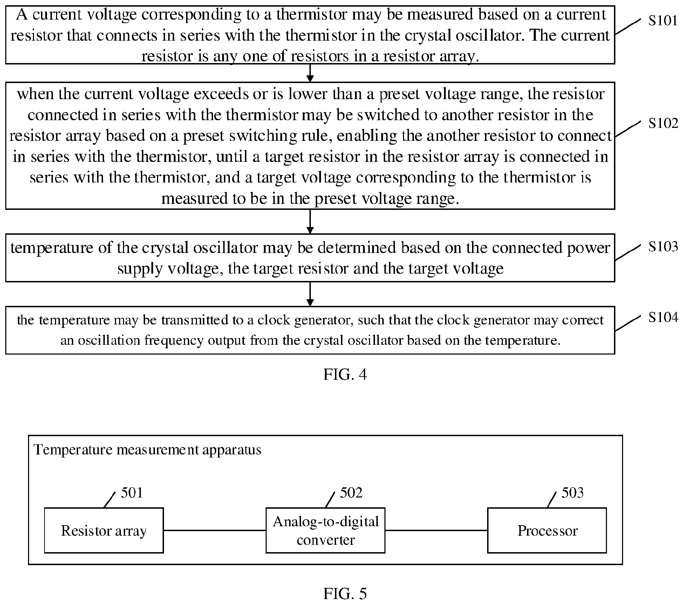

FIG. 4 is a flow chart II of a method for measuring temperature according to an embodiment of the present disclosure. As shown in FIG. 4, after the operation S103, the operation S104 may be included.

In an operation S104, the temperature may be transmitted to a clock generator, such that the clock generator may correct an oscillation frequency output from the crystal oscillator based on the temperature.

In the present embodiment, the temperature measurement apparatus may transmit the temperature to the clock generator, such that the clock generator may correct the oscillation frequency output from the crystal oscillator based on the temperature.

It shall be understood that, in the present embodiment, the clock generator may receive the oscillation frequency output from the crystal oscillator. However, the output oscillation frequency may be inaccurate due to temperature variation of the crystal oscillator. Therefore, the clock generator may adjust the received oscillation frequency in a certain way based on the temperature in order to provide the oscillation frequency to a specific component, and so on.

To be noted that, in the present embodiment, based on the above method for measuring the temperature, in an actual measurement process, the temperature may be measured periodically, which will not be limited by the present disclosure.

According to the present disclosure, the method for measuring the temperature is provided. Based on the current resistor connected in series with the thermistor in the crystal oscillator, the current voltage corresponding to the thermistor may be measured. The current resistor may be any one of the resistors in the resistor array. When the current voltage exceeds or is lower than the preset voltage range, the resistor connected in series with the thermistor may be switched to be another resistor in the resistor array based on the preset switching rule, until the target resistor in the resistor array is connected in series with the thermistor, and the target voltage corresponding to the thermistor is measured to be within the preset voltage range. The temperature of the crystal oscillator may be determined based on the connected power supply voltage, the target resistor and the target voltage. In other words, the resistor that is in the resistor array and is connected in series with the thermistor of the crystal oscillator may be switched for measuring the temperature, the accuracy of temperature measurement may be improved, and the range of temperature that is able to be measured may be expanded.

Embodiment II

The present disclosure provides an apparatus for measuring temperature. FIG. 5 is a structural schematic view of an apparatus for measuring temperature according to an embodiment of the present disclosure. As shown in FIG. 5, the apparatus may include: a resistor array 501, an analog-to-digital converter 502, and a processor 503.

The analog-to-digital converter 502 may be configured to measure a current voltage corresponding to a thermistor based on a current resistor that connects in series with the thermistor in the crystal oscillator. The current resistor is any one of resistors in the resistor array 501.

The processor 503 may be configured to switch the resistor connected in series with the thermistor into another resistor in the resistor array 501 based on a preset switching rule, when the current voltage exceeds or is lower than a preset voltage range, until a target resistor in the resistor array is connected in series with the thermistor, and the target voltage that corresponds to the thermistor and is measured by the analog-to-digital converter 502 is in the preset voltage range. The processor 503 may be configured to determine temperature of the crystal oscillator based on connected power supply voltage, the target resistor and the target voltage.

Alternatively, the processor 503 may be configured to successively switch resistors in the resistor array 501 to connect in series with the thermistor, when the current voltage exceeds the preset voltage range, wherein each of the connected resistors has a nominal resistance value greater than the resistance value of the current resistor. The processor 503 may be configured to successively switch resistors in the resistor array 501 to connect in series with the thermistor, when the current voltage is lower than the preset voltage range, wherein each of the connected resistors has the nominal resistance value less than the resistance value of the current resistor.

Alternatively, in the process of switching the resistor in the resistor array to be connect in series with the thermistor based on the preset switching rule, the processor 503 may be configured to successively determine a corrected resistance value of each resistor that is switched to be connected, until a corrected resistance value of the target resistor is determined.

Alternatively, the processor 503 may be configured to measure a first voltage corresponding to the thermistor when the current resistor is switched into a first resistor in the resistor array, enabling the first resistor to be connected in series with the thermistor; to obtain a corrected resistance value of the current resistor; to determine a corrected resistance value of the first resistor based on the power supply voltage, the current voltage, the corrected resistance value of the current resistor and the first voltage. The processor 503 may be configured to measure a second voltage corresponding to the thermistor when the first resistor is switched into a second resistor in the resistor array, enabling the second resistor to be connected in series with the thermistor; and to determine a corrected resistance value of the second resistor based on the power supply voltage, the first voltage, the corrected resistance of the first resistor, and the second voltage, until the corrected resistance value of the target resistor is determined.

Alternatively, the processor 503 may be configured to determine a nominal resistance of the current resistor as the corrected resistance value of the current resistor when the current resistor is the first resistor in the resistor array 501 connected in series with the thermistor.

Alternatively, the processor 503 may be configured to obtain a corrected resistance value of a historical resistor in the resistor array 501 and a corresponding historical voltage of the thermistor when being connected in series with the historical resistor, in response to the current resistor being not the first resistor connected in series with the thermistor. The historical resistor may be a previous resistor in the resistor array connected in series with the thermistor before the current resistor is connected in series with the thermistor. The processor 503 may be configured to determine an actual resistance value of the current resistor based on the power supply voltage, the corrected resistance value of the historical resistor, the history voltage, and the current voltage.

Alternatively, the processor 503 may be configured to obtain a corrected resistance value of the target resistor; and determine the temperature based on the power supply voltage, the corrected resistance value of the target resistor, and the target voltage.

Alternatively, the processor 503 may be configured to transmit the temperature to a clock generator enabling the clock generator to correct an oscillation frequency output from the crystal oscillator based on the temperature.

The present disclosure provides an apparatus for measuring the temperature. The current voltage corresponding to the thermistor may be measured based on the current resistance that is connected in series with the thermistor in the crystal oscillator. The current resistance is any one of the resistors in the resistor array. When the current voltage exceeds or is lower than the preset voltage range, the resistor connected in series with the thermistor may be switched into another resistor in the resistor array based on the preset switching rule, until the target resistor in the resistor array is connected in series with the thermistor, and the target voltage corresponding to the thermistor is measured to be within the preset voltage range. The temperature of the crystal oscillator may be determined based on the connected power supply voltage, the target resistor, and the target voltage. In other words, the temperature measurement apparatus provided in the present disclosure performs temperature measurement by switching resistors in the resistor array to be connected in series with the thermistor of the crystal oscillator. The accuracy of temperature measurement may be improved, and the range of temperature that is able to be measured may be expanded.

Embodiments of the present disclosure provide a computer readable storage medium. The computer readable storage medium stores a computer program. The above mentioned method for measuring the temperature may be implemented when the computer program is executed by a processor and an analog-to-digital converter. The computer readable storage medium may be a volatile memory, such as Random-Access Memory (RAM); or a non-volatile memory, such as Read-Only Memory (ROM), a flash memory, a Hard Disk Drive (HDD) or a Solid-State Drive (SSD); or a respective device including any one or combination of the above memories, such as a mobile phone, a computer, a tablet device, a personal digital assistant, and so on.

It shall be understood by those skilled in the art that embodiments of the present disclosure may be provided as a method, a system, or a computer program product. Therefore, the present disclosure may take the form of a hardware embodiment, a software embodiment, or an embodiment combining software and hardware aspects. Further, the present disclosure may take the form of a computer program product implemented on one or more computer usable storage media (including, but not limited to, disk memory and optical memory, etc.) containing computer usable program code therein.

The present disclosure is described by referring to the flow charts and/or block diagrams of the methods, devices (systems), and computer program products according to embodiments of the present disclosure. It shall be understood that each process and/or block in the flow chart and/or block diagram, and the combination of processes and/or blocks in the flow chart and/or block diagram, may be implemented by computer program instructions. These computer program instructions may be provided to a processor of a general purpose computer, a specialized computer, an embedded processor, or other programmable signal processing device to produce a machine such that the instructions executed by the processor of the computer or other programmable signal processing device produce a device for implementing the functions specified in one or more processes of the flow chart and/or one or more blocks of the block diagram.

These computer program instructions may also be stored in a computer readable memory capable of directing a computer or other programmable signal processing device to operate in a particular manner such that the instructions stored in such computer readable memory produce an article of manufacture including an instruction device that implements the function specified in one or more processes of the flow chart and/or one or more blocks of the block diagram.

These computer program instructions may also be loaded onto a computer or other programmable signal processing devices such that a series of operations are executed on the computer or other programmable devices to produce computer-implemented processing such that the instructions executed on the computer or other programmable devices provide the operations used to implement the functions specified in one or more processes of the flow chart and/or one or more blocks of the block diagram.

The above only describes preferred embodiments of the present disclosure and does not limit the scope of the present disclosure.

Industrial practicality

According to the technical solutions of the embodiments of the present disclosure, the current voltage corresponding to the thermistor may be measured based on the current resistance that is connected in series with the thermistor in the crystal oscillator. The current resistance is any one of the resistors in the resistor array. When the current voltage exceeds or is lower than the preset voltage range, the resistor connected in series with the thermistor may be switched into another resistor in the resistor array based on the preset switching rule, until the target resistor in the resistor array is connected in series with the thermistor, and the target voltage corresponding to the thermistor is measured to be within the preset voltage range. The temperature of the crystal oscillator may be determined based on the connected power supply voltage, the target resistor, and the target voltage. In other words, in the technical solutions of the present disclosure, resistors in the resistor array may be switched to be connected in series with the thermistor of the crystal oscillator to measure the temperature. The accuracy of temperature measurement may be improved, and the range of temperature that is able to be measured may be expanded.

**Claims**

1.  A method for measuring temperature, comprising:

    measuring a current voltage corresponding to a thermistor based on a current resistor that is connected in series with the thermistor in the crystal oscillator, wherein the current resistor is any one of resistors in a resistor array; switching the resistor into another resistor in the resistor array, enabling the another resistor to be connected in series with the thermistor, based on a preset switching rule, when the current voltage is greater or lower than a preset voltage range, until a target resistor in the resistor array is connected in series with the thermistor, and a target voltage corresponding to the thermistor is measured to be within the preset voltage range; and determining temperature of the crystal oscillator based on connected power supply voltage, the target resistor and the target voltage.

2. The method according to claim 1, wherein the switching the resistor into another resistor in the resistor array, enabling the another resistor to be connected in series with the thermistor, based on a preset switching rule, comprises:

   successively switching the resistors in the resistor array to be connected in series with the thermistor when the current voltage is greater than the preset voltage range, wherein each of the switched resistors has a nominal resistance value greater than a resistance value of the current resistor; and
   successively switching the resistors in the resistor array to be connected in series with the thermistor when the current voltage is lower than the preset voltage range, wherein each of the switched resistors has a nominal resistance value less than a resistance value of the current resistor.

3. The method according to claim 1, wherein after the measuring a current voltage corresponding to a thermistor, the method further comprises:
   successively determining a corrected resistance value of the resistor that is switched to be connected in series with the thermistor, in a process of switching the resistors in the resistor array to connect in series with the thermistor based on the preset switching rule, until a corrected resistance value of the target resistor is determined.

4. The method according to claim 3, wherein the successively determining a corrected resistance value of the resistor that is switched to be connected in series with the thermistor, until a corrected resistance value of the target resistor is determined, comprises:

   measuring a first voltage corresponding to the thermistor, when the current resistor is switched into a first resistor in the resistor array, enabling the first resistor to be connected in series with the thermistor;
   obtaining a corrected resistance value of the current resistor;
   determining a corrected resistance value of the first voltage based on based on the power supply voltage, the current voltage, the corrected resistance value of the current resistor, and the first voltage; and
   in response to the first resistor being not the target resistor, switching the first resistor into a second resistor in the resistor array, enabling the second resistor to connect in series with the thermistor, measuring a second voltage corresponding to the thermistor, and determining a corrected resistance value of the second resistor based on the power supply voltage, the first voltage, the corrected resistance value of the first voltage and the second voltage, until a corrected resistance value of the target resistor being determined.

5. The method according to claim 4, wherein the obtaining a corrected resistance value of the current resistor, comprises:
   determining a nominal resistance value of the current resistor as the corrected resistance value of the current resistor when the current resistor connected in series with the thermistor is a first resistor of the resistor array.

6. The method according to claim 4, wherein the obtaining a corrected resistance value of the current resistor, comprises:

   obtaining a corrected resistance value of a historical resistor in the resistor array and a historical voltage corresponding to the thermistor connected in series with the historical resistor when the current resistor connected in series with the thermistor is not a first resistor in the resistor array, wherein the historical resistor is a resistor which is in the resistor array and is connected in series with the thermistor before the current resistor is connected; and
   determining the corrected resistance value of the current resistor based on the power supply voltage, the corrected resistance value of the historical resistor, the historical voltage and the current voltage.

7. The method according to claim 1, wherein the determining temperature of the crystal oscillator based on connected power supply voltage, the target resistor and the target voltage, comprises:

   obtaining a corrected resistance value of the target resistor; and
   determining the temperature based on the power supply voltage, the corrected resistance value of the target resistor and the target voltage.

8. The method according to claim 1, wherein after the determining temperature of the crystal oscillator based on connected power supply voltage, the target resistor and the target voltage, the method further comprises:
   transmitting the temperature to a clock generator, such that the clock generator corrects an oscillation frequency output from the crystal oscillator based on the temperature.

9. An apparatus for measuring temperature, comprising: a resistor array, an analog-to-digital converter, and a processor, wherein

the analog-to-digital converter is configured to measure a current voltage corresponding to a thermistor in a crystal oscillator based on a current resistor that connects in series with the thermistor, wherein the current resistor is any one of resistors in the resistor array; and
the processor is configured to:

switch the resistor connected in series with the thermistor into another resistor in the resistor array based on a preset switching rule, when the current voltage is greater than or lower than a preset voltage range, until a target resistor in the resistor array is connected in series with the thermistor, and a target voltage corresponding to the thermistor is measured to be within the preset voltage range; and
determine temperature of the crystal oscillator based on connected power supply voltage, the target resistor and the target voltage.

10. The apparatus according to claim 9, wherein the processor is configured to:

successively switch the resistors in the resistor array to be connected in series with the thermistor when the current voltage is greater than the preset voltage range, wherein each of the switched resistors has a nominal resistance value greater than a resistance value of the current resistor; and
successively switch the resistors in the resistor array to be connected in series with the thermistor when the current voltage is lower than the preset voltage range, wherein each of the switched resistors has a nominal resistance value less than a resistance value of the current resistor.

11. The apparatus according to claim 9, wherein the processor is configured to:
successively determine a corrected resistance value of the resistor that is switched to be connected in series with the thermistor, in a process of switching the resistors in the resistor array to connect in series with the thermistor based on the preset switching rule, until a corrected resistance value of the target resistor is determined.

12. The apparatus according to claim 11, wherein the processor is configured to:

measure a first voltage corresponding to the thermistor, when the current resistor is switched into a first resistor in the resistor array, enabling the first resistor to be connected in series with the thermistor;
obtaining a corrected resistance value of the current resistor;
determining a corrected resistance value of the first voltage based on based on the power supply voltage, the current voltage, the corrected resistance value of the current resistor, and the first voltage; and
in response to the first resistor being not the target resistor, switch the first resistor into a second resistor in the resistor array to enable the second resistor to connect in series with the thermistor, and measure a second voltage corresponding to the thermistor, and determine a corrected resistance value of the second resistor based on the power supply voltage, the first voltage, the corrected resistance value of the first voltage and the second voltage, until a corrected resistance value of the target resistor being determined.

13. The apparatus according to claim 12, wherein the processor is configured to:
determine a nominal resistance value of the current resistor as the corrected resistance value of the current resistor when the current resistor connected in series with the thermistor is a first resistor of the resistor array.

14. The apparatus according to claim 12, wherein the processor is configured to:

obtain a corrected resistance value of a historical resistor in the resistor array and a historical voltage corresponding to the thermistor connected in series with the historical resistor when the current resistor connected in series with the thermistor is not a first resistor in the resistor array, wherein the historical resistor is a resistor which is in the resistor array and is connected in series with the thermistor before the current resistor is connected; and
determine the corrected resistance value of the current resistor based on the power supply voltage, the corrected resistance value of the historical resistor, the historical voltage and the current voltage.

15. The apparatus according to claim 9, wherein the processor is configured to:

obtain a corrected resistance value of the target resistor; and

determine the temperature based on the power supply voltage, the corrected resistance value of the target resistor and the target voltage.

16. The apparatus according to claim 9, wherein the processor is configured to:
transmit the temperature to a clock generator, such that the clock generator corrects an oscillation frequency output from the crystal oscillator based on the temperature.

17. A computer-readable storage medium, wherein the storage medium stores a computer program, the computer program is configured to implement the method according to any one of claims 1-8 when being executed by a processor and an analog-to-digital converter.

| A current voltage corresponding to a thermistor may be measured based on a current resistor that connects in series with the thermistor in the crystal oscillator. The current resistor is any one of resistors in a resistor array. | S101 |

↓

| when the current voltage exceeds or is lower than a preset voltage range, the resistor connected in series with the thermistor may be switched to another resistor in the resistor array based on a preset switching rule, enabling the another resistor to connect in series with the thermistor, until a target resistor in the resistor array is connected in series with the thermistor, and a target voltage corresponding to the thermistor is measured to be in the preset voltage range. | S102 |

↓

| temperature of the crystal oscillator may be determined based on the connected power supply voltage, the target resistor and the target voltage | S103 |

FIG. 1

FIG. 2

Measure $V_{ADC1}$

exceeds or is lower than the preset voltage range

Record $V_{ADC1}$ and $R_{X1}$

The first resistor is switched to be connected in series to the thermistor

Record $V_{ADC2}$

Calculate $R_{X2}$ based on $V_{DD}$, $V_{ADC1}$, $R_{X1}$ and $V_{ADC2}$

FIG. 3

| A current voltage corresponding to a thermistor may be measured based on a current resistor that connects in series with the thermistor in the crystal oscillator. The current resistor is any one of resistors in a resistor array. | S101 |

| when the current voltage exceeds or is lower than a preset voltage range, the resistor connected in series with the thermistor may be switched to another resistor in the resistor array based on a preset switching rule, enabling the another resistor to connect in series with the thermistor, until a target resistor in the resistor array is connected in series with the thermistor, and a target voltage corresponding to the thermistor is measured to be in the preset voltage range. | S102 |

| temperature of the crystal oscillator may be determined based on the connected power supply voltage, the target resistor and the target voltage | S103 |

| the temperature may be transmitted to a clock generator, such that the clock generator may correct an oscillation frequency output from the crystal oscillator based on the temperature. | S104 |

FIG. 4

Temperature measurement apparatus

| 501 | 502 | 503 |
| Resistor array | Analog-to-digital converter | Processor |

FIG. 5

**INTERNATIONAL SEARCH REPORT**

International application No.

**PCT/CN2019/088661**

**A. CLASSIFICATION OF SUBJECT MATTER**

G01R 15/09(2006.01)i; G01K 7/22(2006.01)i

According to International Patent Classification (IPC) or to both national classification and IPC

**B. FIELDS SEARCHED**

Minimum documentation searched (classification system followed by classification symbols)

G01R,G01K

Documentation searched other than minimum documentation to the extent that such documents are included in the fields searched

Electronic data base consulted during the international search (name of data base and, where practicable, search terms used)

CNKI, CNPAT, WPI, EPODOC: OPPO广东移动, 晶体振荡器, 温度, 测量, 热敏电阻, 自动, 量程, 切换, 改变, 变换, 档位, 并联, 校正阻值, 标称阻值, temperature, measur+, resistance, auto+, switch+, range

**C. DOCUMENTS CONSIDERED TO BE RELEVANT**

| Category* | Citation of document, with indication, where appropriate, of the relevant passages | Relevant to claim No. |
|---|---|---|
| X | CN 101470145 A (BEIJING INSTITUTE OF MACHINERY) 01 July 2009 (2009-07-01) description, page 2, paragraph 3 (from the bottom) to page 5, the last paragraph, and figures 1-3 | 1-3, 7-11, 16-17 |
| A | CN 101118190 A (杨如祥 等 (YANG, Ruxiang et al.)) 06 February 2008 (2008-02-06) entire document | 1-17 |
| A | CN 103809028 A (ROBERT BOSCH GMBH) 21 May 2014 (2014-05-21) entire document | 1-17 |
| A | CN 1249811 A (ERICSSON INC.) 05 April 2000 (2000-04-05) entire document | 1-17 |
| A | CN 203849312 U (SHANGHAI ULTIMATE POWER COMMUNICATIONS TECHNOLOGY CO., LTD.) 24 September 2014 (2014-09-24) entire document | 1-17 |
| A | CN 2209335 Y (SHENFENG ELECTRONIC INSTRUMENT CO., LTD., (SHENZHEN)) 04 October 1995 (1995-10-04) entire document | 1-17 |
| A | CN 1455262 A (ZHU, Xiaojie) 12 November 2003 (2003-11-12) entire document | 1-17 |

☑ Further documents are listed in the continuation of Box C.      ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **21 February 2020** | **03 March 2020** |

| Name and mailing address of the ISA/CN | Authorized officer |
|---|---|
| **China National Intellectual Property Administration (ISA/CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2019/088661** |

**C.     DOCUMENTS CONSIDERED TO BE RELEVANT**

| Category* | Citation of document, with indication, where appropriate, of the relevant passages | Relevant to claim No. |
|---|---|---|
| A | US 6794859 B2 (CHOI, Sang J.) 21 September 2004 (2004-09-21)<br>    entire document | 1-17 |

Form PCT/ISA/210 (second sheet) (January 2015)

## INTERNATIONAL SEARCH REPORT
### Information on patent family members

International application No.

**PCT/CN2019/088661**

| Patent document cited in search report | | | Publication date (day/month/year) | Patent family member(s) | | | Publication date (day/month/year) |
|---|---|---|---|---|---|---|---|
| CN | 101470145 | A | 01 July 2009 | CN | 101470145 | B | 29 December 2010 |
| CN | 101118190 | A | 06 February 2008 | None | | | |
| CN | 103809028 | A | 21 May 2014 | FR | 2998062 | A1 | 16 May 2014 |
| | | | | CH | 707219 | A2 | 15 May 2014 |
| | | | | KR | 20140062417 | A | 23 May 2014 |
| | | | | DE | 102012220738 | A1 | 15 May 2014 |
| | | | | CH | 707219 | B1 | 31 May 2018 |
| | | | | FR | 2998062 | B1 | 21 July 2017 |
| CN | 1249811 | A | 05 April 2000 | EP | 0965031 | A1 | 22 December 1999 |
| | | | | BR | 9807989 | A | 08 March 2000 |
| | | | | KR | 20000075877 | A | 26 December 2000 |
| | | | | EE | 9900381 | A | 17 April 2000 |
| | | | | AU | 6681898 | A | 22 September 1998 |
| | | | | JP | 2001516529 | A | 25 September 2001 |
| | | | | WO | 9839624 | A1 | 11 September 1998 |
| CN | 203849312 | U | 24 September 2014 | None | | | |
| CN | 2209335 | Y | 04 October 1995 | None | | | |
| CN | 1455262 | A | 12 November 2003 | None | | | |
| US | 6794859 | B2 | 21 September 2004 | US | 2004095124 | A1 | 20 May 2004 |